# EUROPÄISCHE PATENTANMELDUNG

(11) **EP 1 655 782 A1**
(43) Veröffentlichungstag der Anmeldung: **10.05.2006**
(21) Anmeldenummer: 05023832.8
(22) Anmeldetag: 02.11.2005
(51) Int. Cl.: H01L 29/737, H01L 29/10, H01L 21/331, H01L 27/07, H01L 29/06

(54) **Halbleiteranordnung und Verfahren zur Herstellung einer Halbleiteranordnung**

(30) Priorität: 05.11.2004 DE 102004053394
(71) Anmelder: ATMEL Germany GmbH, 74072 Heilbronn (DE)
(72) Erfinder: Bromberger, Christoph, Dipl.-Phys., 74074 Heilbronn (DE)

(57) **Zusammenfassung**

Verfahren zur Herstellung einer Halbleiteranordnung, insbesondere eines Hochfrequenzbipolartransistors, indem folgende Verfahrensschritte in Reihenfolge erfolgen, so dass
a) ein Dielektrikum auf einem monokristallinen, ersten Halbleitergebiet eines ersten Leitungstyps erzeugt wird,
b) eine Silizidschicht abgeschieden und derart strukturiert wird, dass die Silizidschicht durch das Dielektrikum von dem ersten Halbleitergebiet isoliert ist,
c) ein zweites Halbleitergebiet eines zweiten Leitungstyps zur Ausbildung eines Basisbereichs auf das erste Halbleitergebiet und auf die Silizidschicht derart aufgebracht, wird, dass das zweite Halbleitergebiet mit einer ersten Grenzfläche auf dem ersten Halbleitergebiet und mit einer zweiten Grenzfläche auf der Silizidschicht aufliegt.

## Beschreibung

Die vorliegende Erfindung betrifft eine Halbleiteranordnung und ein Verfahren zur Herstellung einer Halbleiteranordnung.

In der DE 43 01 333 A1 werden verschiedene Prozessschritte beim Herstellungsverfahren eines NPN-Silizium-Germanium-Heterobipolartransistors mit einer P-Silizium-Germanium Basisschicht offenbart. Auf diese Schrift wird vollumfänglich Bezug genommen und die Prozessschritte in den Figuren 1 a bis 1i erläutert.

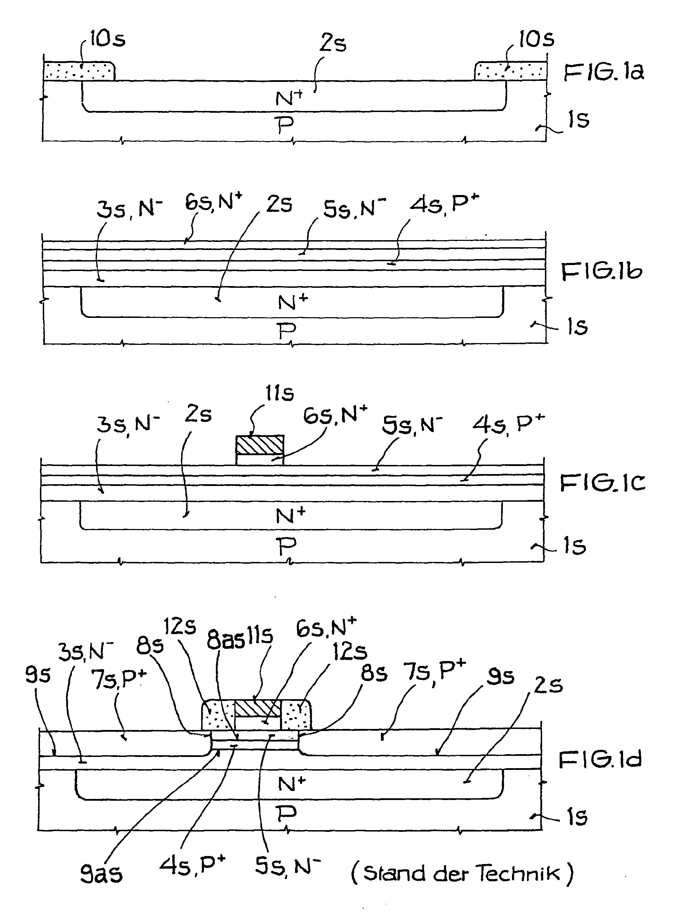

Fig. 1a: Auf der Oberfläche einer P-dotierten Silizium-Substratscheibe 1 s wird durch thermische Oxidation eine (Maskier-) Oxidschicht 10s gebildet und unter Verwendung von Fotolack strukturiert; eine N⁺-Kollektoranschlussschicht 2s ("burried layer") wird durch Implantation und Nachdiffusion von Arsen-Ionen gebildet.

Fig. 1b: Nach Entfernen der Maskier-Oxidschicht 10s wird die Schichtenfolge des SiGe-HBTs in einem einzigen Prozess (beispielsweise mittels Molekularstrahlepitaxie MBE) ohne Unterbrechung bei gleichzeitiger Dotierung der Schichten gewachsen. Die Schichtenfolge umfasst die N-Kollektorschicht 3s (bspw. mit einer Schichtdicke 300 nm und einer Dotierungskonzentration von 10¹⁶ bis 10¹⁷ cm⁻³), die P⁺-SiGe-Basisschicht 4s (Germaniumanteil beispielsweise 20%, Schichtdicke 50 nm und Dotierungskonzentration 10¹⁹ cm⁻³), die N⁻-Emitterschicht 5s (bspw. mit einer Schichtdicke von 100 nm und einer Dotierungskonzentration von 10¹⁸ cm⁻³) sowie die N⁺-Emitteranschlussschicht 6s bspw. Schichtdicke 50 nm und Dotierungskonzentration größer 10²⁰ cm⁻³).

Fig. 1c: Auf die N⁺-Emitteranschlussschicht 6s wird ganzflächig (beispielsweise durch CVD-Verfahren) eine Hilfsschicht 11s (beispielsweise aus Siliziumnitrid Si₃N₄) mit einer Schichtdicke von ca. 0,3 µm abgeschieden und mittels Fotolack strukturiert; ein Teilbereich der Si₃N₄-Hilfsschicht 11 s und der Si-Emitteranschlussschicht 6s wird anisotrop abgeätzt - die Emitterschicht 5s verbleibt weiterhin über der SiGe-Basisschicht 4s.

Fig. 1d: Auf die Oberfläche der Halbleiteranordnung wird eine CVD-Oxid (TEOS) 12s (beispielsweise mit einer Schichtdicke von 0,3 µm) konform abgeschieden und derart anisotrop rückgeätzt, dass nur an den senkrechten Kanten der Hilfsschicht 11 s und der Emitteranschlussschicht 6s eine Oxidschicht 12s (Spacer) verbleibt und die restliche Oberfläche (für den Basisanschluss) freigelegt wird; in die freiliegende Oberfläche werden BF2-Ionen (Dosis beispielsweise 4 x 10¹⁵ cm⁻², Beschleunigungsspannung beispielsweise 40 - 80 kV) bis in eine Tiefe knapp unterhalb der SiGe-Basisschicht 4s implantiert und dadurch das seitlich der Oxidspacer 12s liegende Emittergebiet 5s zum P⁺-Basisanschlussgebiet 7s umdotiert sowie der Basis-Kollektor-PN-Übergang 9s unter die Basis-Kollektor-Grenzschicht 9as und der Emitter-Basis-PN-Übergang 8s unter die Spacer-Oxidschicht 12s verschoben.

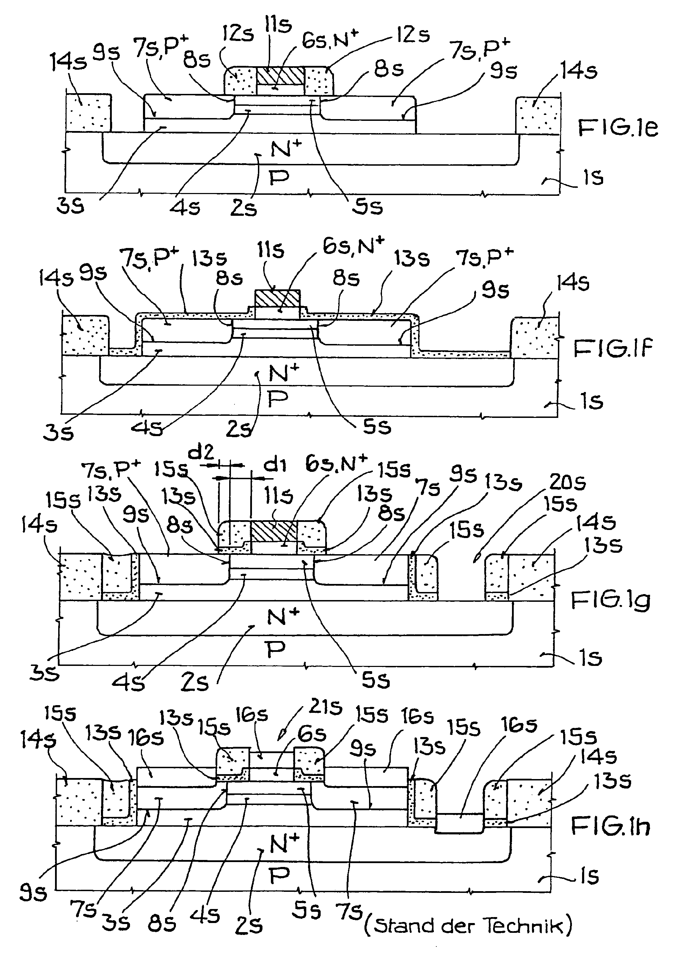

Fig. 1e: Die endgültige Mesastruktur wird herausgebildet, indem Basisanschlussgebiet 7s und Kollektorschicht 3s durch anisotropes Ätzen strukturiert werden; durch Abscheidung und Strukturierung eines CVD-Oxids (Schichtdicke beispielsweise 0,5 µm) werden Feldoxidgebiete 14s gebildet, die die einzelnen Bauelemente bzw. aktiven Strukturen der integrierten Schaltung voneinander separieren.

Fig. 1f: Durch thermische Oxidation bei einer Temperatur von beispielsweise 700°C wird die freiliegende Oberfläche der Halbleiteranordnung mit einer beispielsweise 10 nm dicken SiO₂-Schicht 13s überzogen. Sowohl der Basis-Emitter-PN-Übergang 8s als auch der Kollektor-Basis-PN-Übergang 9s werden an der Oberfläche passiviert und somit vor Leckströmen geschützt.

Fig. 1g: Auf die Oberfläche der Halbleiteranordnung wird ganzflächig ein CVD-Oxid 15s (TEOS) abgeschieden (bspw. mit einer Schichtdicke von 0,5 µm) und derart anisotrop rückgeätzt, dass zum einen die Kollektor-Kontaktöffnung 20s gebildet wird und zum anderen Oxidspacer 15s verbleiben, die die Oberfläche des Basis-Emitter-PN-Übergangs 8s über eine Länge d₂ schützen. Die Abstände d₁ (vom Rand der Emitteranschlussschicht 6s bis zum Basisanschlussgebiet 7s) und d₂ (vom Basisanschlussgebiet 7s bis zum späteren Basis-Metall 16s) werden durch die beschriebene Spacertechnik unter Verwendung der Oxidschichten 12s und 15s selbstjustiert und minimal.

Fig. 1h: Der restliche Teil der Si₃N₄-Hilfsschicht 11 s wird entfernt und die Emitter-Kontaktöffnung 21s freigelegt. Durch Aufdampfen einer Metallschicht 16s (beispielsweise Titan) und deren Temperaturbehandlung wird auf der Oberfläche der Silizium-Bereiche 2s, 6s, 7s ein Metall-Silizid (Bsp. TitanSilizid) gebildet, während auf der Oberfläche der Oxidbereiche 13s, 14s, 15s das reine Metall verbleibt; die Metallschicht über den Oxidbereichen 13s, 14s, 15s wird mittels einer Ätzlösung selektiv entfernt. Anschließend kann nach Aufbringen einer Oxidschicht und Herstellung von Kontaktöffnungen für Emitter, Basis und Kollektor eine Metallisierung mittels üblicher Verfahren aufgebracht werden. Derartige SiGe-HBTs der Fig. 1 h können jedoch nicht nur, wie dargestellt, auf einfach strukturierten Substraten gefertigt werden, sondern beispielsweise auch auf Substraten, die bereits fertige Bauelemente in reiner Silizium-Technologie (bspw. MOS oder Bipolar) enthalten.

Die Basis des zuvor beschriebenen Transistors lässt sich gedanklich in eine innere Basis und eine äußere Basis gliedern. Die innere Basis bildet mit angrenzenden Emitter- und Kollektorgebieten ebene und im Wesentlichen parallele pn-Übergänge aus, während die äußere Basis zur elektrischen Verbindung der inneren Basis mit zumindest einem äußeren Kontakt ausgebildet ist.

Für viele Anwendungen von Bipolartransistoren, so beispielsweise für die Hochfrequenz-Leistungsverstärkung, ist der Basiswiderstand ein wichtiger Parameter, der die elektrischen Eigenschaften der Transistoren, insbesondere deren Grenzfrequenz begrenzt. Häufig wird der Basiswiderstand vom Widerstand der äußeren Basis dominiert.

Um den Widerstand der äußeren Basis zu reduzieren, ist die äußere Basis in hochdotiertem Halbleitermaterial vom selben Dotierstofftyp wie dem der inneren Basis ausgeführt, jedoch mit einer erheblich höheren Schichtdicke, um so einen niedrigen Schichtwiderstand zu erzielen. Bei dem in der Druckschrift "IEEE-IEDM 2002, Artikel 31.6.1" gelehrten Verfahren wird beispielsweise die äußere Basis in Polysilizium einer Schichtdicke ausgeführt, die erheblich über der Weite der inneren Basis liegt. Zudem kann die äußere Basis als hochdotierter implantierter Bereich ausgeführt sein.

Um den Widerstand der äußeren Basis von Bipolartransistoren der Siliziumtechnologie zu reduzieren, wird die äußere Basis silizidiert, wie dies bspw. in den Druckschriften US 5,459,084, US 6,177,717, US 2002/0168829 oder US 6,465,317 ausgeführt ist. Hierbei wird auf die äußere Basis eine Schicht aus einem mit Silizium reaktionsfähigen Metall aufgebracht und dieses mit dem Siliziummaterial der äußeren Basis zur Reaktion gebracht. Durch ein Tempern oberhalb einer Umwandlungstemperatur werden die entstehenden Silizide in eine Modifikation mit einem geringen spezifischen Widerstand überführt.

Für viele Anwendungen, insbesondere im Hochfrequenzbereich, ist es wünschenswert, neben Silizium ein weiteres Halbleitermaterial, beispielsweise Germanium oder Kohlenstoff, in die innere Basis eines Bipolartransistors einzubringen, um einen Heterobipolartransistor herzustellen. Bei der epitaktischen Abscheidung des Halbleitermaterials für die innere Basis wird auch in Teile der äußeren Basis neben Silizium das weitere Halbleitermaterial eingebracht. Germanium und Kohlenstoff verhalten sich chemisch ähnlich wie Silizium, so dass ein mit Silizium reaktionsfähiges Metall unter den selben Reaktionsbedingungen auch mit Germanium oder Kohlenstoff reagiert.

Insbesondere Verbindungen zwischen Titan und Germanium weisen eine geringere thermische Stabilität auf als homologe Verbindungen zwischen Titan und Silizium und dissoziieren bei der Umwandlungstemperatur der Silizide. Die bei der Dissoziierung gebildeten Germanium- und Titan-Ausscheidungen wirken widerstandserhöhend.

Bei Vorhandensein eines weiteren Halbleitermaterials (Germanium) in der inneren Basis kann es daher wünschenswert sein, die Silizidierungsreaktion so zu führen, dass die Silizidierungsfront nicht bis in die Tiefe der inneren Basis vordringt. Dennoch ist zur Verringerung des Basiswiderstandes eine hohe Siliziddicke wünschenswert.

Hierzu ist, wie zuvor in der DE 43 01 333 A1 beschrieben, eine dicke Emitterschicht 5s vorgesehen, die dazu dient, Siliziummaterial für eine dicke Silizidschicht 16s vorzuhalten, ohne dass die Silizidierungsfront bis in die Tiefe der Schicht 4s aus Silizium-Germanium-Mischmaterial vordringt. Am Rand des dicken Emittergebietes wird eine relativ großflächiger pn-Übergang ausgebildet, wobei der pn-Übergang vollständig im Silizium liegt. Der Basis-Emitter-Diode des Heterobipolartransistors ist eine relativ großflächige Silizium-Diode parallel geschaltet. Diese beeinflusst die elektrischen Eigenschaften des entstehenden Bauelementes und begrenzt dessen geometrische Skalierbarkeit.

Aus der DE 198 45 790 A1 ist ein Herstellungsverfahren für SiGe-Heterobipolartransistoren unter Vermeidung großflächiger Silizium-Randtransistoren bekannt, indem zur nasschemischen Abdünnung von Siliziumschichten im aktiven Emittergebiet eines Bipolartransistors, eine zusätzlich mittels "Atomic Layer Doping" (ALD) in eine Deckelschicht eingebrachte Dotierung mit einer Dicke kleiner 3 nm als Ätzstoppschicht für nasschemische Ätzmittel wirkt. Nachfolgend wird die Ätzstoppschicht mit einem nasschemischen Ätzmittel entfernt wird.

Das Schichtwachstum der Deckelschicht erfolgt über der Ätzstoppschicht weiter einkristallin, so dass mit Hilfe eines Silizium-Ätzmittels, das einkristalline Silizium der Deckelschicht hochselektiv zur Ätzstoppschicht und zu einem Dielektrikum entfernt werden kann. In einer Ausführungsform des Verfahrens der DE 198 45 790 A1 wird die epitaktische Abscheidung der dicken Emitterschicht unterbrochen durch Aufbringen der dünnen Ätzstopschicht, beispielsweise aus hoch-p-dotiertem Silizium, die als Ätzstop bei einer selektiven, nasschemischen Dünnung der dicken Emitterschicht zur Eintiefung des Emitterfensters, am Ort des Emitterfensters dient.

Aus der Druckschrift "IEEE IEDM 2003, Technical Digest, Artikel 5.3.1" ist ebenfalls ein Herstellungsverfahren unter Vermeidung relativ großflächiger Randtransistoren bekannt, indem auf der äußeren Basis eine hohe Siliziddicke erzielt wird, während gleichzeitig die Silizidierungsfront oberhalb der Germanium enthaltenden Schicht zum Stehen gebracht wird. Hierzu wird das Siliziummaterial nach Fertigstellung des Emitteranschlusses ausschließlich oberhalb der äußeren Basis durch selektive Epitaxie abgeschieden und anschließend silizidiert.

Ein weiterer Nachteil des Standes der Technik ergibt sich aus der Tatsache, dass eine sich bei der Silizidierung herausbildende Grenzfläche zwischen Silizid und Silizium im Allgemeinen uneben ausgeprägt ist. Insbesondere besteht die Gefahr der Bildung nadelförmiger oder pyramidaler Silizid-Kristallite, welche in das Siliziumgebiet hineinragen. Zur Vermeidung eines Kurzschlusses ("spike") zwischen der Silizidschicht auf der äußeren Basis und dem Emittergebiet muss hiernach ein ausreichender lateraler Abstand zwischen der Silizidkante und der Emitterkante vorgesehen werden. Hierdurch wird der Bahnwiderstand der äußeren Basis nachteilig erhöht.

Insbesondere bei den in den Schriften US 6,5181,111 und US 6,239,477 gelehrten Verfahren wird versucht, den Basis-Bahnwiderstandsanteil aufgrund des nicht silizidierten Bereiches der äußeren Basis zu reduzieren. Hierbei wird zwischen dem Emitterfenster und der äußeren Basis ein großer Mindestabstand gewahrt, um Basis-Emitterkurzschlüsse durch seitlich wachsende Silizidkristalle, so genannte Spikes zu verhindern. Zur Reduktion des Widerstandes wird der Bereich der äußeren Basis, der zwischen dem Silizid und der inneren Basis gelegen ist, durch Dotanden aus einer Feststoff-Dotierstoffquelle möglichst hoch dotiert, ohne die Eigenschaften des Basis-Emitter-PN-Übergangs zu beeinträchtigen.

Als Dotierstoffquelle sieht die US 6,518,111 eine dielektrische Schicht (Bor-Silikat-Glas) als Diffusionsquelle zur Verringerung des Schichtwiderstandes des Verbindungsbereichs zwischen der inneren Basis und einer äußeren Basis aus Polysilizium vor, während die US 6,239,477 eine Dotierung zwischen den inneren Basis und einer silizidierten äußeren Basis vorsieht. In der US 2004/0014271 ist als Feststoffquelle eine selektiv epitaktisch abgeschiedene hochdotierte Siliziumschicht vorgesehen.

Der Erfindung liegt die Aufgabe zu Grunde, den Basiswiderstand möglichst zu reduzieren, wobei die Nachteile großer lateraler Ausdehnung und Einflüsse parasitäre Randtransistoren, die zwischen Anschlussgebieten entstehen können, möglichst reduziert werden.

Diese Aufgabe wird durch ein Verfahren mit den Merkmalen des Anspruchs 1 und durch eine Halbleiteranordnung mit den Merkmalen eines der Ansprüche 17 oder 26 gelöst. Vorteilhafte Weiterbildungen der Erfindung sind Gegenstand von Unteransprüchen.

Demzufolge ist ein Verfahren zur Herstellung einer Halbleiteranordnung vorgesehen. Hergestellt werden vorzugsweise integrierte Hochfrequenzschaltung mit Hochfrequenzbipolartransistoren oder Hochfrequenzbipolartransistoren als Einzelbauelemente.

In diesem Herstellungsverfahren erfolgen zumindest die folgenden Verfahrensschritte in der aufgeführten Reihenfolge, wobei unter Reihenfolge nicht ein zwingendes Aufeinanderfolgen verstanden wird, so dass zwischen den in Reihenfolge aufgeführten Verfahrensschritten der Erfindung weitere Verfahrensschritte, wie lithographische Verfahrensschritte, Reinigungsschritte etc. erfolgen können.

Es wird zunächst ein Dielektrikum auf einem monokristallinen, ersten Halbleitergebiet eines ersten Leitungstyps erzeugt. Das monokristalline Halbleitergebiet ist vorteilhafterweise ein Siliziumsubstrat mit vorzugsweise einer <100> Orientierung.

Eine Silizidschicht wird abgeschieden und derart strukturiert, dass die Silizidschicht durch das Dielektrikum von dem ersten Halbleitergebiet isoliert ist. Die Silizidschicht kann dabei vorzugsweise abschieden werden, indem ein Silizidtarget gesputtert wird. Alternativ können zum Abscheiden der Silizidschicht eine Siliziumschicht und eine Metallschicht, beispielsweise Titan, Kobalt oder Tantal abgeschieden und miteinander zur Reaktion gebracht werden.

Das Wesen der Erfindung besteht darin, dass ein zweites Halbleitergebiet eines zweiten, dem ersten Leitungstyp entgegen gesetzten Leitungstyps zur Ausbildung eines Basisbereichs auf das erste Halbleitergebiet und die Silizidschicht aufgebracht wird. Die Aufbringung erfolgt dabei derart, dass das zweite Halbleitergebiet mit einer ersten Grenzfläche auf dem ersten Halbleitergebiet und mit einer zweiten Grenzfläche auf der Silizidschicht aufliegt. Da das zweite Halbleitergebiet zur Ausbildung des Basisbereichs auf die Silizidschicht aufgebracht wird, kann die Basis von unten angeschlossen werden, indem die Größe der zweiten Grenzfläche den Übergangswiderstand zwischen dem Halbleitermaterial des zweiten Halbleitergebiets der Basis und der Silizidschicht maßgeblich beeinflusst.

Der Erfindung liegt dabei der Gedanke zu Grunde, dass der Übergangswiderstand zwischen der Silizidschicht und dem Halbleitermaterial des zweiten Halbleitergebiets den Basiswiderstand und damit das Hochfrequenzverhalten der Halbleiteranordnung signifikant prägt. Der Anschluss der Basis durch die unterhalb des Halbleitermaterials angeordnete Silizidschicht ermöglichen zudem Freiräume zur Prozessgestaltung der oberhalb des zweiten Halbleitergebiets der Basis angeordneten funktionalen Schicht(en) der Halbleiteranordnung.

Vorteilhafte Weiterbildungen der Erfindung sehen vor, dass vor dem Erzeugen des Dielektrikums eine Hartmaske auf einer ersten Siliziumoberfläche des ersten Halbleitergebiets erzeugt wird und Teile des ersten Halbleitergebiets, die nicht von der Hartmaske bedeckt sind, selektiv entfernt werden. Dies ermöglicht, die Silizidschicht seitlich von dem aktiven Kollektor-Basisbereich mit der Kollektorbasisraumladungszone anzuordnen, und das zweite Halbleitergebiet im wesentlichen plan auszubilden. Zudem kann das selektive Entfernen von Teilen des ersten Halbleitergebiet vorteilhaft genutzt werden, eine Grabenstruktur auszubilden, die eine Distanzierung des ersten Halbleitergebiets von Anschlussbereichen der Basis ermöglicht. Dies bezweckt, eine parasitäre Kapazität zwischen dem ersten Halbleitergebiet, das vorteilhafterweise als Kollektor fungiert, und der Basis zu reduzieren.

In einer Ausgestaltung der Erfindung ist es vorteilhaft, dass das Dielektrikum erzeugt wird, indem die nach dem selektiven Entfernen freiliegende Oberfläche des ersten Halbleitergebiets thermisch oxidiert wird und/oder eine oder mehrere dielektrische Schichten abgeschieden werden. Das thermische Oxid oder die abgeschiedenen dielektrischen Schichten können zudem anschließend vorteilhafterweise strukturiert werden.

In einer Ausgestaltung der Erfindung wird das thermische Oxid und/oder eine oder mehrere dielektrische Schichten vor einem Aufbringen des zweiten Halbleitergebietes aufgebracht und strukturiert.

Weiterhin ist es vorteilhaft vor dem Aufbringen des zweiten Halbleitergebiets die Oberfläche des Wafers bis zur Hartmaske zu planarisieren und die Hartmaske zu entfernen. Die Planarisierung ermöglicht einen im Wesentlichen planare Ausgestaltung des zweiten Halbleitergebiets und weiterer darauf aufgebrachter Schicht, um vorzugsweise im Wesentlichen plane PN-Übergänge zu erzeugen.

Eine erste Ausgestaltungsvariante der Erfindung sieht vor, dass die Oberfläche des Wafers planarisiert wird, indem der Wafer chemisch-mechanisch poliert (CMP) wird. In dieser Ausgestaltungsvariante kann die Hartmaske vorteilhafterweise als Planarisierungsstop verwendet werden.

Eine zweite, alternative Ausgestaltungsvariante der Erfindung sieht eine Planarisierung der Oberfläche des Wafers vor, indem Lack mit einer entsprechenden Oberflächenspannung aufgeschleudert wird und dieser somit eine ebene Oberfläche bildet. Durch Trockenätzen wird der Wafer gleichmäßig vorzugsweise bis zur ersten Siliziumoberfläche des ersten Halbleitergebiets gedünnt. Hierzu kann beispielsweise auf Zeit geätzt werden.

In einer besonders bevorzugten Weiterbildung der Erfindung ist vorgesehen, das zur Herausbildung des zweiten Halbleitergebietes eine Silizium-Germanium-Schicht epitaktisch aufgebracht wird. Vorteilhafterweise ist der erste Leitungstyp der n-Leitungstyp und die Silizium-Germanium-Schicht p-dotiert, wenn insbesondere ein npn-Hochfrequenzbipolartransistor hergestellt werden soll. Für einen pnp-Transistor ist die Zuordnung entsprechend invers, demnach für einen pnp-Transistor der erste Leitungstyp der p-Leitungstyp wäre und die Silizium-Germanium-Schicht n-dotiert.

Für einen npn-Transistor ist in einer vorteilhaften Weiterbildung der Erfindung vorgesehen, dass zur Herausbildung des zweiten Halbleitergebietes eine n-dotierte Siliziumschicht und auf diese eine p-dotierte Silizium-Germanium-Schicht aufgebracht wird. Dabei wird die Siliziumschicht durch einen Temperschritt durch Dotanden für den p-Leitungstyp, ausgehend von der als Dotierstoffquelle wirkenden Silizidschicht, umdotiert wird.

Hierzu wird beispielsweise Bor oder ein anderer Dotand für Silizium in die Silizidschicht zuvor eingebracht, beispielsweise implantiert oder in situ während des Abscheidens der Silizidschicht zugefügt. Diese Fremdstoffe in der Silizidschicht wirken nach deren Ausdiffusion in die n-dotierte Siliziumschicht dort als Dotanden. Aufgrund einer höheren Dotierstoffkonzentration der ausdiffundierten Dotanden des p-Leitungstyps gegenüber der Dotierstoffkonzentration der Dotanden des n-Leitungstyps wird diese Siliziumschicht umdotiert und bildet somit einen niederohmigen Übergang zwischen der Silizidschicht und der Silizium-Germanium-Schicht des zweiten Halbleitergebiets.

Die Erfindung weiterbildend ist vorteilhafterweise vorgesehen, dass Halbleitermaterial des zweiten Halbleitergebietes amorph abgeschieden und durch Festphasenepitaxie zur Auskristallisation gebracht wird. Die Auskristallisation erfolgt dabei derart, dass die entstehende Kristallstruktur von einer als Kristallisationskeim wirkenden Oberfläche des ersten Halbleitergebiets ausgehend dieses monokristallin fortsetzt. Die monokristalline Fortsetzung der Kristallstruktur erfolgt dabei zumindest in vertikaler Richtung. Vorteilhafterweise wird zudem eine messbare laterale monokristalline Fortsetzung zumindest über das Dielektrikum erzielt.

Eine andere Ausgestaltung der Erfindung sieht vor, dass die Silizidschicht aus bordotiertem Kobaltsilizid gebildet wird und oberhalb des nach der Planarisierung verbleibenden Materials der Silizidschicht zumindest ein Teil des zweiten Halbleitergebiet, insbesondere dessen Siliziummaterial, durch Ausdiffusion von Bor aus der Kobaltsilizidschicht zu p-dotiertem Halbleitermaterial umdotiert wird.

In einer weiterführenden Ausgestaltung der Erfindung ist vorgesehen, dass oberhalb des zweiten Halbleitergebietes ein drittes Halbleitergebiet eines Zwischenbasisbereiches und ein viertes Halbleitergebiet eines weiteren Basisbereiches aufgebracht wird. Vorzugsweise entspricht dabei der Leitungstyp des ersten Halbleitergebiets dem Leitungstyp des dritten Halbleitergebiets. Vorzugsweise entspricht zudem der Leitungstyp des zweiten Halbleitergebiets dem Leitungstyp des vierten Halbleitergebiets. Oberhalb des vierten Halbleitergebietes des weiteren Basisbereichs wird eine weitere Silizidschicht aufgebracht.

Die Erfindung weiterbildend wird nach dem Aufbringen der weiteren Silizidschicht in der weiteren Silizidschicht eine Öffnung erzeugt, indem die weitere Silizidschicht im Bereich der Öffnung entfernt wird. Nachfolgend wird innerhalb der Öffnung ein Emitterbereich ausgebildet. Vorzugsweise wird die Position der Öffnung dabei zu der Position der Silizidschicht und der Position des ersten Halbleitergebietes derart justiert, dass die Grenzflächen des ersten Halbleitergebietes zum zweiten Halbleitergebiet, des zweiten Halbleitergebietes zum dritten Halbleitergebiet, des dritten Halbleitergebietes zum vierten Halbleitergebiet und des vierten Halbleitergebietes zum Emitterhalbleitergebiet im Wesentlichen vertikal übereinander und vorzugsweise parallel zueinander angeordnet sind.

In einer anderen Weiterbildung der Erfindung ist vorgesehen, dass zur Aufbringung des vierten Halbleitergebietes des weiteren Basisbereichs eine Silizium-Germanium-Schicht und eine erste Siliziumschicht aufgebracht wird, wobei die erste Siliziumschicht zwischen der Silizium-Germanium-Schicht und der weiteren Silizidschicht eingefügt wird, indem diese erste Siliziumschicht vor dem Aufbringen der weiteren Silizidschicht auf eine erste Oberfläche der Silizium-Germanium-Schicht des vierten Halbleitergebietes des weiteren Basisbereichs aufgebracht wird.

Vorteilhafterweise wird zudem zwischen der weiteren Silizidschicht und der ersten Siliziumschicht eine zweite Siliziumschicht des vierten Halbleitergebiets eingebracht, indem die zweite Siliziumschicht vor dem Aufbringen der weiteren Silizidschicht auf eine zweite Oberfläche der ersten Siliziumschicht aufgebracht wird, wobei vorzugsweise die zweite Siliziumschicht gegenüber der ersten Siliziumschicht eine höhere Dotierstoffkonzentration aufweist.

Eine bevorzugte Ausgestaltung der Erfindung sieht vor, dass die Öffnung, in welcher im weiteren Verlauf des Verfahrens der Emitterbereich ausgebildet werden wird, mit einer Tiefe zumindest bis zur zweiten Oberfläche der ersten Siliziumschicht oder bis zur ersten Oberfläche der Silizium-Germanium-Schicht des vierten Halbleitergebietes der weiteren Basisschicht erzeugt wird.

Die Erfindung weiterbildend ist vorgesehen, dass sowohl in die Silizidschicht, als auch in die weitere Silizidschicht Fremdstoffe eingebracht werden, die beispielsweise zugleich mit Hilfe von einem Temperschritt oder mehrerer Temperschritte in das angrenzende zweite Halbleitergebiet, beziehungsweise in das angrenzende vierte Halbleitergebiet eindiffundiert werden und in diesen beiden Halbleitergebieten als Dotanden desselben Leitungstyps wirken.

Ein weiterer Aspekt der Erfindung ist eine Halbleiteranordnung. Diese kann beispielsweise nach den zuvor erläuterten Verfahrensschritten hergestellt sein.

Die Halbleiteranordnung weist ein monokristallines, erstes Halbleitergebiet eines ersten Leitungstyps auf. Dies ist beispielsweise ein n-dotiertes Siliziumsubstrat. Weiterhin weist die Halbleiteranordnung ein zweites Halbleitergebiet eines zweiten Leitungstyps auf, das an der Grenzfläche zum ersten Halbleitergebiet monokristallin ausgebildet ist. Neben weiteren monokristallinen Gebieten kann das zweite Halbleitergebiet auch polykristalline oder amorphe Bereiche aufweisen. Aufgrund des unterschiedlichen Leitungstyps bildet sich an der Grenzfläche ein PN-Übergang aus.

Eine Silizidschicht der Halbleiteranordnung weist die eine Grenzfläche zu dem zweiten Halbleitergebiet auf. Die Silizidschicht kann ein oder mehrere Silizide, wie Kobaldsilizid, Titansilizid oder Tantalsilizid aufweisen. Die Grenzfläche kann beispielsweise in einem polykristallinen Bereich des zweiten Halbleitergebiets ausgebildet sein.

Dabei sind sowohl das erste Halbleitergebiet als auch die Silizidschicht unterhalb des zweiten Halbleitergebiets angeordnet und voneinander isoliert. Das zweite Halbleitergebiet bildet einen Basisbereich, der durch die angrenzende Silizidschicht angeschlossen ist. Vorzugsweise ist der Basisbereich im wesentlichen plan ausgebildet.

Bevorzugt weist das zweite Halbleitergebiet eine SiGe-Schicht auf. Der Anteil des Germanium kann über die Dicke der Schicht dabei variieren. Auch die SiGe-Schicht ist im Bereich der Grenzfläche zu dem ersten Halbleitergebiet monokristallin ausgebildet und setzt bevorzugt die Kristallstruktur des ersten Halbleitergebiets monokristallin fort.

Insbesondere um bei einer epitaktischen Abscheidung der SiGe-Schicht eine Kontamination des Epitaxie-Materials durch den Übergangsmetallanteil der Silizidschicht zu vermeiden, ist in einer vorteilhaften Weiterbildung der Erfindung vorgesehen, dass das zweite Halbleitergebiet zwischen der SiGe-Schicht und der Grenzfläche zur Silizidschicht eine Siliziumschicht aufweist, wobei diese Siliziumschicht vorzugsweise durch Festphasenepitaxie amorph abgeschiedenen Siliziums, ausgehend von der Grenzfläche zum ersten Halbleitergebiet als Kristallisationskeim, erzeugt wird.

Um einen kleinen Übergangswiderstand zwischen der Silizidschicht und der Silizium-Germanium-Schicht zu erreichen ist in einer anderen bevorzugten Weiterbildung der Erfindung vorgesehen, dass die Siliziumschicht ausgehend von der als Dotierstoffquelle wirkenden Silizidschicht mit Dotanden desselben Leitungstyps wie dessen der Silizium-Germanium-Schicht dotiert ist.

Zum Anschluss der Basis innerhalb eines Metallisierungssystems ist gemäß einer vorteilhaften Ausgestaltung der Erfindung vorgesehen, dass ein Metallkontakt zum Anschluss des Basisbereichs innerhalb einer Öffnung in dem zweiten Halbleitergebiet auf der Silizidschicht angeordnet ist. Dies ist insbesondere dann vorteilhaft, wenn ein direkter Kontakt zwischen dem Halbleitermaterial und dem Metall des Metallkontaktes vermieden werden soll.

Eine alternative Ausgestaltung der Erfindung sieht vor, dass ein Metallkontakt zum Anschluss des Basisbereichs auf dem zweiten Halbleitergebiet angeordnet ist. Auch ist es möglich den Metallkontakt sowohl auf der Silizidschicht als auch auf dem Halbleitermaterial des zweiten Halbleitergebietes anzuordnen.

Ein weiterer Aspekt der Erfindung ist eine Verwendung einer zuvor erläuterten Halbleiteranordnung in einem Hochfrequenzhalbleiterbauelement, beispielsweise in einem Hochfrequenzbipolartransistor und/oder in einer vertikal integrierten Hochfrequenzkaskodenanordnung einer integrierten Schaltung.

Ein anderer Aspekt der Erfindung ist eine Halbleiteranordnung mit einem ersten Basisbereich und einem zweiten Basisbereich. Dabei sind die beiden Basisbereiche voneinander beabstandet. Zum Anschluss der ersten Basis ist eine erste Silizidschicht unterhalb des ersten Basisbereichs angeordnet, die an diesen ersten Basisbereich angrenzt. Zum Anschluss der zweiten Basis ist eine zweite Silizidschicht oberhalb des zweiten Basisbereichs angeordnet, die an diesen zweiten Basisbereich angrenzt.

Dieser unterschiedliche Anschluss der beiden Basen ermöglicht jeweils optimierte elektrische Eigenschaften der Anschlüsse als auch eine möglichst unabhängige Prozessintegration der Anschlüsse.

Diesen Aspekt der Erfindung weiterbildend ist dabei vorgesehen, dass der erste Basisbereich und der zweite Basisbereich durch einen Zwischenbasisbereich vertikal voneinander beabstandet sind. Der Zwischenbasisbereich ist dabei von einem ersten Leitungstyp, beispielsweise einem n-Leitungstyp, und die beiden Basisbereich sind von einem zweiten Leitungstyp, beispielsweise einem p-Leitungstyp. Dabei grenzen sowohl der erste Basisbereich als auch der zweite Basisbereich an den Zwischenbasisbereich an.

Die Erfindung weiter ausgestaltend weisen der erste Basisbereich und/oder der zweite Basisbereich ein Halbleitergebiet mit einer Silizium-Germanium-Schicht auf. Vorzugsweise ist diese Silizium-Germanium-Schicht dabei von einer Silizidschicht durch eine Siliziumschicht separiert angeordnet.

Eine Weiterbildung der Erfindung sieht vor, dass der erste Basisbereich und der zweite Basisbereich im Wesentlichen plan und parallel zueinander ausgebildet sind. Vorteilhafterweise wird zudem die Gitterstruktur des Halbleitermaterials des ersten Basisbereich durch die Gitterstruktur des Zwischenbasisbereichs und des zweiten Basisbereichs monokristallin fortgesetzt, so dass vorzugsweise die den beiden Basisbereichen zugehörigen Raumladungszonen der PN-Übergänge innerhalb der monokristallinen Gitterstruktur angeordnet sind.

Ein wiederum andere Aspekt der Erfindung ist eine Verwendung einer zuvor beschriebenen Halbleiteranordnung in einer vertikal integrierten Kaskodenanordnung, insbesondere einer Hochfrequenzschaltung.

Im Folgenden wird die Erfindung in Ausführungsbeispielen anhand von zeichnerischen Darstellungen näher erläutert.

Dabei zeigen
- Fig. 1a bis 1h: eine schematische Darstellung eines Herstellungsprozesses eines HBTs nach dem Stand der Technik,
- Fig. 2: eine schematische Schnittansicht durch eine Struktur des Wafers vor einer Planarisierung,
- Fig. 3: eine schematische Schnittansicht durch eine Struktur des Wafers nach einer Planarisierung und Aufbringen einer Silizium-Germanium-Schicht,
- Fig. 4: eine schematische Schnittansicht durch eine Struktur des Wafers nach einer Planarisierung und einem Aufbringen einer Siliziumschicht und einer Silizium-Germanium-Schicht, und
- Fig. 5: eine schematische Schnittansicht durch eine vertikal integrierten Kaskodenanordnung.

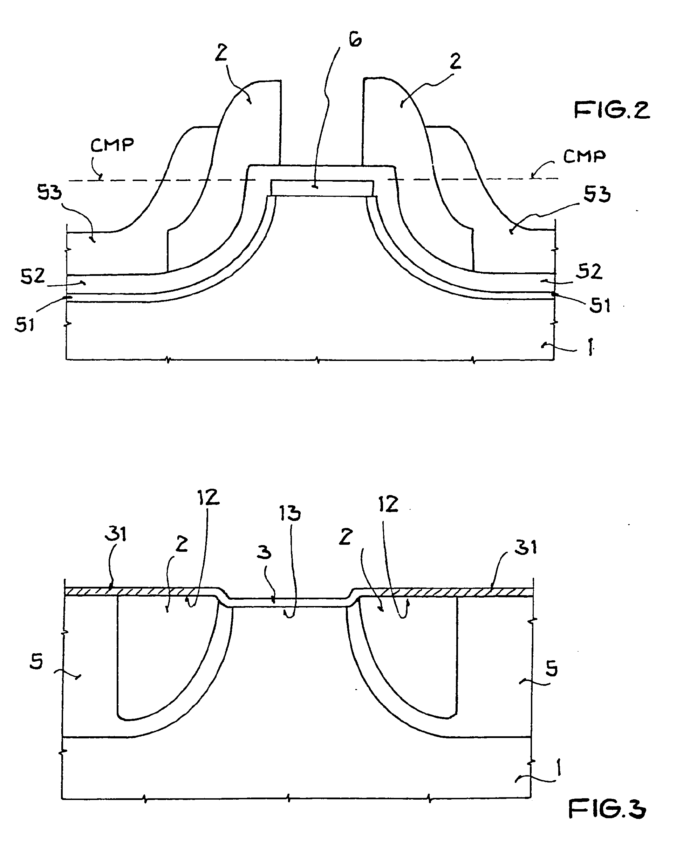

In Fig. 2 ist eine schematische Schnittansicht durch eine Struktur eines Wafers vor einem Planarisierungsschritt gezeigt. Eine Hartmaske 6 aus Si₃N₄ und unterliegendem thermischen Oxid ist auf ein bereits strukturiertes erstes (n-dotiertes) Halbleitergebiet 1 aufgebracht, das einen Kollektorbereich bildet. Weiterhin ist ein thermisches Oxid 51 (SiO₂) gebildet und eine erste dielektrische Schicht 52 abgeschieden. Auf diese erste abgeschiedene, dielektrische Schicht 52 ist eine Silizidschicht 2 und eine zweite dielektrische Schicht 53 abgeschieden und nachfolgend strukturiert worden. Mittels des Planarisierungsschrittes soll die dargestellte Mehrschichtstruktur auf die gestrichelt eingezeichnete Linie (CMP) planarisiert werden. Hierzu kann beispielsweise ein chemisch-mechanisches Polierverfahren (CMP) genutzt werden.

In Fig. 3 ist ein Ausführungsbeispiel der Erfindung nach weiteren Verfahrensschritten dargestellt. Nach erfolgter Planarisierung ist ein zweites (p-dotiertes) Halbleitergebiet 3 mit einer Silizium-Germanium-Schicht aufgebracht worden, die eine erste Grenzfläche 13 zu dem ersten Halbleitergebiet und eine Grenzfläche 12 zu der Silizidschicht 2 aufweist. Im Bereich der ersten Grenzfläche 13 setzt die Silizium-Germanium-Schicht des zweiten Halbleitergebiets 3 die monokristalline Gitterstruktur des ersten Halbleitergebietes 1 in vertikaler Richtung und in einem Lateralbereich auch in lateraler Richtung fort. Die monokristalline Kristallisation in lateraler Richtung wird dabei durch Festphasenepitaxie erreicht. Zumindest im Bereich einer weiteren Grenzfläche zu dem Dielektrikum 5 weist das zweite Halbleitergebiet polykristalline oder amorphe Schichtbereiche 31 auf.

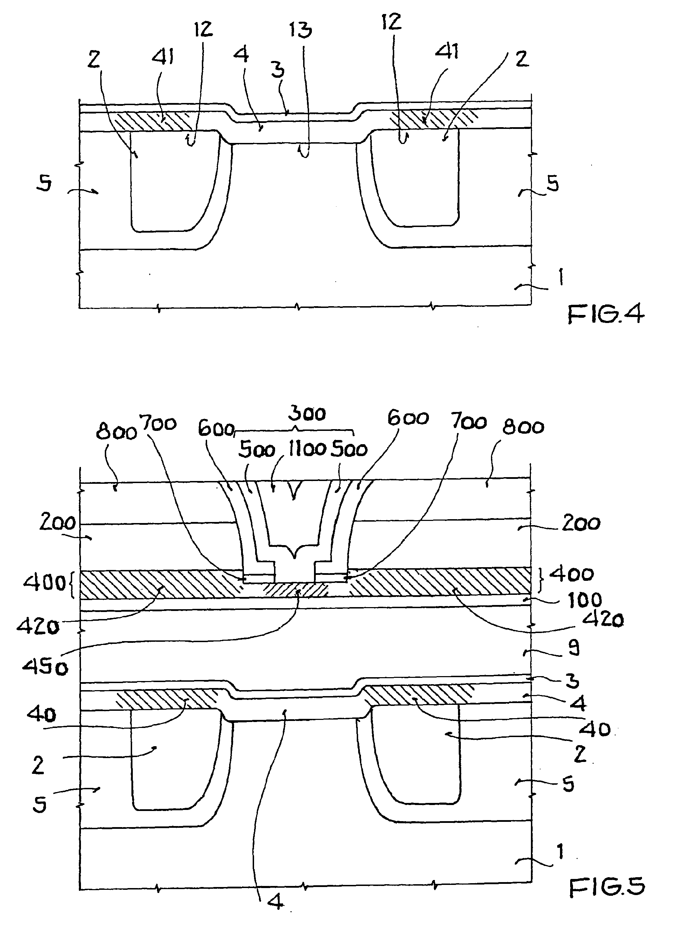

Fig. 4 zeigt eine schematische Schnittansicht eines anderen Ausführungsbeispiels der Erfindung. Hierbei besteht das zweiten Halbleitergebiet 3, 4 aus einer Silizium-Germanium-Schicht 3 und einer unterhalb der Silizium-Germanium-Schicht 3 angeordneten Siliziumschicht 4, die beide das monokristalline Metallgitter des ersten Halbleitergebietes fortsetzten.

Die Siliziumschicht 4 wird zunächst schwach n-dotiert aufgebracht und im Bereich der Silizidschicht 2 in einen p-dotierten Bereich umdotiert. Die Umdotierung kann beispielsweise, ausgehend von der Silizidschicht 2 als Festkörperquelle, in welche Silizidschicht 2 zu diesem Zwecke beispielsweise Bor in situ während der Erzeugung oder durch Implantation eingebracht wurde, vorgenommen werden. Um die Siliziumschicht 4 aufzubringen, kann man beispielsweise von einer Festphasenepitaxie Gebrauch machen, indem zunächst eine relativ dünne (bspw. 40 nm) amorphe, schwach n-dotierte Siliziumschicht, gefolgt von einer relativ dicken (bspw. 300 nm), hoch n-dotierten amorphen Siliziumschicht, abgeschieden wird. Durch Temperaturbeaufschlagung werden, ausgehend von der Grenzfläche 13 zu dem ersten Halbleitergebiet 1, die amorphen Bereiche oberhalb der Grenzfläche 13 vertikal, sowie teilweise der Bereich oberhalb der Grenzfläche 12 in lateraler Richtung, per Festphasenepitaxie monokristallin kristallisiert.

Die hoch n-dotierte Siliziumschicht dient hierbei der Unterstützung der Festphasenepitaxie in lateraler Richtung. Nach erfolgter Festphasenepitaxie wird die hoch n-dotierte Siliziumschicht durch ein Ätzmittel entfernt, welches selektiv hochdotierte Siliziumbereiche entfernt. Anschließend wird die Siliziumschicht 4 oberflächlich oxidiert und die gebildete Oxidschicht abgenommen. Der Oxidationsschritt dient hierbei der Reinigung der Oberfläche. Gleichzeitig diffundieren während des Oxidationsschrittes die in die Silizidschicht 2 eingebrachten Boratome in die Siliziumschicht 4 aus. Verbleibende amorphe bzw. entstehende polykristalline Bereiche der Siliziumschicht 4 sind in der Fig. 4 durch Schraffuren angedeutet.

Fig. 5 zeigt eine schematische Schnittansicht durch eine vertikal integrierte Kaskodenanordnung, die vorzugsweise in einer Hochfrequenzschaltung verwendet wird. Für die folgende Beschreibung gelten die Leitungstypen für eine Hochfrequenz-npnpn-Kaskode. Der Kollektorbereich ist durch eine n-dotierte Schicht 1 gebildet, die einen vertikalen Dotierungsgradienten für eine höhere Sperrspannung aufweisen kann (in Fig. 5 nicht dargestellt).

Zur Vereinfachung der Darstellung wird in Fig. 5 davon ausgegangen, dass bei der Festphasenepitaxie keine amorphen oder polykristallinen Bereiche verbleiben, bzw. entstehen. Schraffuren kennzeichnen in Fig. 5 daher durch Ausdiffusion aus benachbarten Bereichen dotierte Gebiete.

Es ist ein erster Basisbereich (3, 4) mit einer ersten, p-dotierten Silizium-Germanium-Halbleiterschicht 3 und ein zweiter Basisbereich (100, 400) mit einer zweiten, p-dotierten Silizium-Germanium-Schicht 100 vorgesehen. Zwischen dem ersten Basisbereich (3, 4) und dem zweiten Basisbereich (100, 400) ist ein n-dotierter Zwischenbasisbereich (9) mit einer Siliziumschicht angeordnet, an den beide Basisbereiche (3, 4, 100, 400) grenzen.

Oberhalb des Zwischenbasisbereiches 9 ist der zweite Basisbereich (100, 400) mit der Silizium-Germanium-Schicht 100 angeordnet, der in diesem Ausführungsbeispiel zur vereinfachten Darstellung im aktiven Bereich unterhalb des Emitters lediglich aus einer Schicht (100) besteht. Auf der zweiten, p-dotierten Silizium-Germanium-Schicht 100 ist eine Siliziumschicht 400 angeordnet, die im Gegensatz zur Silizium-Germanium-Schicht 100 kein Germanium aufweisen. Weiterhin ist ein Dielektrikum aus einer Si₃N₄-Schicht 800 vorgesehen.

Oberhalb der Siliziumschicht 400 und somit auch oberhalb des zweiten Basisbereichs (100, 400) ist eine Silizidschicht 200 angeordnet, in die mittels der Hartmaske aus der Si₃N₄-Schicht 800 und ggf. in Fig. 5 nicht dargestellten Spacern eine Öffnung 300 geätzt ist, wobei innerhalb dieser Öffnung 300 in nachfolgenden Schritten der Emitterbereich ausgebildet wird. Durch die Silizidschicht 200 hindurch reicht damit eine Öffnung 300, innerhalb derer der Emitterbereich (500, 1100) angeordnet ist.

Innerhalb der Öffnung 300 sind zwei Innenspacer 600 jeweils oberhalb von einem thermischen Oxid 700 angeordnet. An die Innenspacer 600 angrenzend ist polykristallines oder amorphes, n⁺-(hoch)dotiertes Silizium 500 aufgebracht, das ebenfalls eine Spaceröffnung zwischen den beiden Innenspacern 600 verfüllt. Der verbleibende Teil der Öffnung 300 des Emitterbereichs ist mit einem Silizid 1100 und ggf. weiteren (in Fig. 5 nicht dargestellten) metallischen Leitern verfüllt.

Das Polysilizium 500 dient zudem als Dotierstoffquelle zur Dotierung der monokristallinen Halbleiterschicht 400 in einem Emittergebiet 450, das hierzu durch Dotanden aus dem Polysilizium 500 hoch n⁺-dotiert ist und das aktive Emittergebiet 450 bildet. Weiterhin wirkt die Silizidschicht 200 als Dotierstoffquelle, wobei die Siliziumschicht 400 im Bereich 420 der äußeren Basis hoch p⁺-dotiert ist. Dies ermöglicht einen besonders niederohmigen Anschluss der äußeren Basis (420, 100).

Bezüglich der unterhalb n-dotierten Siliziumschicht des Zwischenbasisbereichs 9 liegenden Bereiche wird auf die Ausführungen zur Fig. 4 verwiesen. Zur vereinfachten Darstellung sind in Fig. 5 die notwendigen Metallanschlüsse in der dargestellten Schnittansicht nicht enthalten. Diese sind vorzugsweise direkt auf die Silizidschichten (2, 200) aufgebracht, so dass diese Metalle eine Grenzfläche zu den anzuschließenden Silizidschichten (2, 200) aufweisen.

Das Herstellungsverfahren zur Herstellung dieser vertikalen Halbleiteranordnung weist folgende Verfahrensschritte auf, wobei die Bezugsziffern auf die Figuren 2 bis 5 verweisen:
- Erzeugen einer Hartmaske 6 auf einer ersten Siliziumoberfläche eines ersten Halbleitergebietes 1, wobei die Hartmaske 6 einen Kollektorbereich 1 aus der Kollektorschicht bedeckt;
- Selektives Entfernen der nicht von der Hartmaske 6 bedeckten Teile der Kollektorschicht;
- Thermisches Oxidieren der nach dem selektivem Entfernen der Kollektorschicht freiliegenden Oberfläche;
- Abscheiden einer ersten dielektrischen Schicht 52;
- Abscheiden und Strukturieren einer ersten Silizidschicht 2;
- Abscheiden und Strukturieren einer zweiten dielektrischen Schicht 53;
- Planarisieren bis zur Oberfläche der Hartmaske 6, durch Abtragen des Materials der ersten dielektrischen Schicht 52, der ersten Silizidschicht 2 und der zweiten dielektrischen Schicht 53;
- Entfernen der Hartmaske 6;
- Aufbringen einer amorphen, n-dotierten Siliziumschicht 4;
- Kristallisation der amorphen, n-dotierten Siliziumschicht 4 durch Festphasenepitaxie, ausgehend von der durch Entfernen der Hartmaske 6 freigelegten ersten Siliziumoberfläche 13 des ersten Halbleitergebietes 1 als Kristallisationskeim;
- Epitaktisches Abscheiden einer ersten monokristallinen Halbleiterschicht 3 eines zweiten Halbleitergebiets, wobei die erste monokristalline Halbleiterschicht 3 vorzugsweise aus einer ersten p-dotierten SiGe-Schicht 3 gebildet wird,
- Epitaktisches Abscheiden einer zweiten, n-dotierten Siliziumschicht eines dritten Halbleitergebietes 9;
- Epitaktisches Abscheiden einer dritten und vierten monokristallinen Halbleiterschicht eines vierten Halbleitergebietes 100, wobei die dritte monokristalline Halbleiterschicht vorzugsweise aus einer p-dotierten SiGe-Schicht und die vierte Halbleiterschicht aus schwach p-dotiertem Silizium gebildet wird;
- Aufbringen einer Silizidschicht 200 auf das vierte Halbleitergebiet (100, 400), wobei die Oberfläche dieses vierten Halbleitergebietes (100, 400) eine erste Halbleiteroberfläche für nachfolgende Prozessschritte bildet;
- Aufbringen einer dritten dielektrischen Schicht 800;
- Erzeugen einer Öffnung 300 in der dritten dielektrischen Schicht 800 und in der Silizidschicht 200, durch welche vorzugsweise die erste Halbleiteroberfläche freigelegt wird;
- Erzeugen von Innenspacern 600 in der Öffnung 300; und
- Ausbilden eines Emitterbereichs (500, 1100) in der Öffnung 300.

Weiterhin ist es vorteilhaft auf die Kristallisation der amorphen, n-dotierten Siliziumschicht durch Festphasenepitaxie folgende Verfahrensschritte folgen zu lassen:
- Bilden einer weiteren thermischen Oxidschicht durch teilweises Oxidieren der kristallisierten n-dotierten Siliziumschicht;
- Selektives Umdotieren der nach der Oxidation verbleibenden kristallisierten n-dotierten Siliziumschicht durch selektive Implantation von Dotierstoffen vom p-Dotierungstyp in das Siliziummaterial oberhalb des nach dem Planarisierungsschritt verbliebenen Materials der ersten Silizidschicht;
- Ausheilen der Implantationsschäden durch einen thermischen Prozess;
- Entfernen der weitern thermischen Oxidschicht.

## Patentansprüche

1. Verfahren zur Herstellung einer Halbleiteranordnung, insbesondere eines Hochfrequenzbipolartransistors, indem folgende Verfahrensschritte in Reihenfolge erfolgen, so dass
a) ein Dielektrikum (5, 51, 52) auf einem monokristallinen, ersten Halbleitergebiet (1) eines ersten Leitungstyps erzeugt wird,
b) eine Silizidschicht (2) abgeschieden und derart strukturiert wird, dass die Silizidschicht (2) durch das Dielektrikum (5, 51, 52) von dem ersten Halbleitergebiet (1) isoliert ist,
c) ein zweites Halbleitergebiet (3,4) eines zweiten Leitungstyps zur Ausbildung eines Basisbereichs auf das erste Halbleitergebiet (1) und auf die Silizidschicht (2) derart aufgebracht, wird, dass das zweite Halbleitergebiet (3, 4) mit einer ersten Grenzfläche (13) auf dem ersten Halbleitergebiet (1) und mit einer zweiten Grenzfläche (12) auf der Silizidschicht (2) aufliegt.

2. Verfahren nach Anspruch 1, **dadurch gekennzeichnet, dass**
vor dem Erzeugen des Dielektrikums (5, 51, 52)
- eine Hartmaske (6) auf einer ersten Siliziumoberfläche des ersten Halbleitergebiets (1) erzeugt wird und
- Teile des ersten Halbleitergebiets (1), die nicht von der Hartmaske (6) bedeckt sind, selektiv entfernt werden.

3. Verfahren nach Anspruch 2, **dadurch gekennzeichnet, dass** das Dielektrikum (5, 51, 52) erzeugt wird, indem die nach dem selektiven Entfernen freiliegende Oberfläche des ersten Halbleitergebiets (1) thermisch oxidiert wird und/oder eine oder mehrere dielektrische Schichten (52) abgeschieden werden.

4. Verfahren nach einem der vorhergehenden Ansprüche, **dadurch gekennzeichnet, dass** vor dem Aufbringen des zweiten Halbleitergebiets (3, 4) ein oder mehrere weitere Dielektrika (53) aufgebracht und strukturiert werden.

5. Verfahren nach einem der vorhergehenden Ansprüche, **dadurch gekennzeichnet, dass** vor dem Aufbringen des zweiten Halbleitergebiets (3,4)
- die Oberfläche des Wafers bis zur Hartmaske (6) planarisiert und
- die Hartmaske (6) entfernt wird.

6. Verfahren nach einem der vorhergehenden Ansprüche, **dadurch gekennzeichnet, dass** die Oberfläche des Wafers planarisiert wird, indem der Wafer chemisch-mechanisch poliert (CMP) wird.

7. Verfahren nach einem der vorhergehenden Ansprüche, **dadurch gekennzeichnet, dass** die Oberfläche des Wafers planarisiert wird, indem
- Lack mit einer entsprechenden Oberflächenspannung aufgeschleudert wird und somit eine ebene Oberfläche bildet, und
- durch Trockenätzen der Wafer gleichmäßig vorzugsweise bis zur ersten Siliziumoberfläche des ersten Halbleitergebiets (1) gedünnt wird.

8. Verfahren nach einem der vorhergehenden Ansprüche, **dadurch gekennzeichnet, dass** der erste Leitungstyp der n-Leitungstyp ist und zur Aufbringung des zweiten Halbleitergebietes (3, 4) des zweiten Leitungstyps eine p-dotierte Silizium-Germanium-Schicht epitaktisch aufgebracht wird.

9. Verfahren nach einem der vorhergehenden Ansprüche, **dadurch gekennzeichnet, dass** zur Aufbringung des zweiten Halbleitergebietes (3, 4) eine n-dotierte Siliziumschicht und auf dieser eine p-dotierte Silizium-Germanium-Schicht aufgebracht wird, wobei die Siliziumschicht durch einen Temperschritt durch Dotanden für den p-Leitungstyp ausgehend von der als Dotierstoffquelle wirkenden Silizidschicht (2) umdotiert wird.

10. Verfahren nach einem der vorhergehenden Ansprüche, **dadurch gekennzeichnet, dass** Halbleitermaterial des zweiten Halbleitergebietes (3, 4) amorph abgeschieden und durch Festphasenepitaxie derart zur Auskristallisation gebracht wird, dass die entstehende Kristallstruktur von einer als Kristallisationskeim wirkenden Oberfläche des ersten Halbleitergebiets (1) ausgehend dieses monokristallin fortsetzt.

11. Verfahren nach einem der vorhergehenden Ansprüche, **dadurch gekennzeichnet, dass** die Silizidschicht (2) aus bordotiertem Kobaltsilizid gebildet wird und oberhalb des nach der Planarisierung verbleibenden Materials der Silizidschicht (2) zumindest ein Teil des zweiten Halbleitergebiet (3, 4), insbesondere dessen Siliziummaterial durch Ausdiffusion von Bor aus der Kobaltsilizidschicht zu p-dotiertem Halbleitermaterial umdotiert wird.

12. Verfahren nach einem der vorhergehenden Ansprüche, **dadurch gekennzeichnet, dass**
- oberhalb des zweiten Halbleitergebietes (3, 4) ein drittes Halbleitergebiet (9) eines Zwischenbasisbereich und ein viertes Halbleitergebiet (100, 400) eines weiteren Basisbereich aufgebracht wird,
- oberhalb des vierten Halbleitergebietes (100, 400) des weiteren Basisbereichs eine weitere Silizidschicht (200) aufgebracht wird,
- nach dem Aufbringen der weiteren Silizidschicht (200) in der weiteren Silizidschicht (200) eine Öffnung (300) erzeugt wird, indem die weitere Silizidschicht (200) im Bereich der Öffnung (300) entfernt wird, und
- nachfolgend innerhalb der Öffnung (300) ein Emitterbereich ausgebildet wird.

13. Verfahren nach Anspruch 12, **dadurch gekennzeichnet, dass** zur Aufbringung des vierten Halbleitergebietes (100, 400) des weiteren Basisbereichs eine Silizium-Germanium-Schicht (100) und eine erste Siliziumschicht (400) aufgebracht wird, wobei die erste Siliziumschicht (400) zwischen der Silizium-Germanium-Schicht (100) und der weiteren Silizidschicht (200) eingefügt wird, indem diese erste Siliziumschicht (400) vor dem Aufbringen der weiteren Silizidschicht (200) auf eine erste Grenzfläche der Silizium-Germanium-Schicht (100) des vierten Halbleitergebietes (100, 400) des weiteren Basisbereichs aufgebracht wird.

14. Verfahren nach Anspruch 13, **dadurch gekennzeichnet, dass** zwischen der weiteren Silizidschicht (200) und der ersten Siliziumschicht eine zweite Siliziumschicht des vierten Halbleitergebiets eingebracht wird, indem die zweite Siliziumschicht vor dem Aufbringen der weiteren Silizidschicht auf eine zweite Grenzfläche der ersten Siliziumschicht aufgebracht wird, wobei vorzugsweise die zweite Siliziumschicht gegenüber der ersten Siliziumschicht eine höhere Dotierstoffkonzentration aufinreist.

15. Verfahren nach einem der Ansprüche 13 oder 14, **dadurch gekennzeichnet, dass** die Öffnung (300) mit einer Tiefe zumindest bis zur zweiten Grenzfläche der ersten Siliziumschicht (400) oder bis zur ersten Grenzfläche der Silizium-Germanium-Schicht (100) des vierten Halbleitergebietes (100, 400) der weiteren Basisschicht erzeugt wird.

16. Verfahren nach einem der vorhergehenden Ansprüche, **dadurch gekennzeichnet, dass** sowohl in die Silizidschicht (2), als auch in die weitere Silizidschicht (200) Fremdstoffe eingebracht werden, die in einem Temperschritt zeitgleich in das angrenzende zweite Halbleitergebiet (3, 4) beziehungsweise in das angrenzende vierte Halbleitergebiet (100, 400) eindiffundieren und in diesen beiden Halbleitergebieten (3, 4, 100, 400) als Dotanden desselben Leitungstyps wirken.

17. Halbleiteranordnung, insbesondere hergestellt nach einem der vorhergehenden Ansprüche, mit
- einem monokristallinen, ersten Halbleitergebiet (1) eines ersten Leitungstyps,
- einem zweiten Halbleitergebiet (3, 4) eines zweiten Leitungstyps, das an der Grenzfläche (13) zum ersten Halbleitergebiet (1) monokristallin ausgebildet ist und
- einer Silizidschicht (2), die eine Grenzfläche (12) zu dem zweiten Halbleitergebiet (3, 4) aufweist,
wobei
- sowohl das erste Halbleitergebiet (1) als auch die Silizidschicht (2) unterhalb des zweiten Halbleitergebiets (3, 4) angeordnet und voneinander isoliert sind, und
- das zweite Halbleitergebiet (3, 4) einen Basisbereich bildet.

18. Halbleiteranordnung nach Anspruch 17, **dadurch gekennzeichnet, dass** zur Isolation ein oder mehrere Dielektrika (5, 51, 52, 53) erzeugt und strukturiert sind.

19. Halbleiteranordnung nach einem der Ansprüche 17 oder 18, **dadurch gekennzeichnet, dass** das zweite Halbleitergebiet (3, 4) eine SiGe-Schicht (3) aufweist.

20. Halbleiteranordnung nach Anspruch 19, **dadurch gekennzeichnet, dass** das zweite Halbleitergebiet (3, 4) zwischen der SiGe-Schicht (3) und der Grenzfläche (12) zur Silizidschicht (2) eine Siliziumschicht (4) aufweist.

21. Halbleiteranordnung nach Anspruch 20, **dadurch gekennzeichnet, dass** die Siliziumschicht (4) ausgehend von der als Dotierstoffquelle wirkenden Silizidschicht (2) dotiert ist.

22. Halbleiteranordnung nach einem der vorhergehenden Ansprüche, **dadurch gekennzeichnet, dass** ein Metallkontakt zum Anschluss des Basisbereichs innerhalb einer Öffnung in dem zweiten Halbleitergebiet (3, 4) auf der Silizidschicht (2) angeordnet ist.

23. Halbleiteranordnung nach einem der vorhergehenden Ansprüche, **dadurch gekennzeichnet, dass** ein Metallkontakt zum Anschluss des Basisbereichs auf dem zweiten Halbleitergebiet (3, 4) angeordnet ist.

24. Halbleiteranordnung nach einem der vorhergehenden Ansprüche, **dadurch gekennzeichnet, dass** der Basisbereich im wesentlichen plan ausgebildet ist.

25. Verwendung einer Halbleiteranordnung eines der vorhergehenden Ansprüche in einem Hochfrequenzhalbleiterbauelement, insbesondere in einem Hochfrequenzbipolartransistor und/oder in einer Hochfrequenzkaskodenanordnung.

26. Halbleiteranordnung, insbesondere nach einem der Ansprüche 17 bis 24, mit
- einem ersten Basisbereich (3, 4) und
- einem zweiten Basisbereich (100, 400), die voneinander beabstandet sind,
wobei
- zum Anschluss der ersten Basis eine erste Silizidschicht (2) unterhalb des ersten Basisbereichs (3, 4) angeordnet ist und an diesen ersten Basisbereich (3, 4) angrenzt,
- zum Anschluss der zweiten Basis eine zweite Silizidschicht (200) oberhalb des zweiten Basisbereichs (100, 400) angeordnet ist und an diesen zweiten Basisbereich (100, 400) angrenzt.

27. Halbleiteranordnung nach Anspruch 26, **dadurch gekennzeichnet, dass** der erste Basisbereich (3, 4) und der zweite Basisbereich (100, 400) durch einen Zwischenbasisbereich (9) vertikal voneinander beabstandet sind und der Zwischenbasisbereich (9) von einem ersten Leitungstyp und die beiden Basisbereiche (3, 4, 100, 400) von einem zweiten Leitungstyp sind, wobei sowohl der erste Basisbereich (3, 4) als auch der zweite Basisbereich (100, 400) an den Zwischenbasisbereich (9) angrenzen.

28. Halbleiteranordnung nach einem der Ansprüche 26 oder 27, **dadurch gekennzeichnet, dass** der erste Basisbereich (3, 4) und/oder der zweite Basisbereich (100, 400) ein Halbleitergebiet mit einer Silizium-Germanium-Schicht (3, 100) aufweisen.

29. Halbleiteranordnung nach einem der Ansprüche 26 bis 28, **dadurch gekennzeichnet, dass** erste Basisbereich (3, 4) und der zweite Basisbereich (100, 400) im Wesentlichen plan und parallel zueinander ausgebildet sind.

30. Verwendung einer Halbleiteranordnung nach einem der Ansprüche 26 bis 29 in einer vertikal integrierten Kaskodenanordnung, insbesondere einer Hochfrequenzschaltung.
